**Europäisches Patentamt**

**European Patent Office**

**Office européen des brevets**

(19)

(11) Numéro de publication: **0 084 746**
**A2**

# (12) DEMANDE DE BREVET EUROPEEN

(21) Numéro de dépôt: **82402124.0**

(51) Int. Cl.³: **G 06 F 13/00**

(22) Date de dépôt: **22.11.82**

(30) Priorité: **30.11.81 FR 8122536**

(71) Demandeur: **INSTITUT FRANCAIS DU PETROLE, 4, Avenue de Bois-Préau, F-92502 Rueil-Malmaison (FR)**
Demandeur: **COMPAGNIE GENERALE DE GEOPHYSIQUE, 6, rue Galvani, F-91301 Massy (FR)**

(72) Inventeur: **Therond, Jean-François, 12, rue de Longchamp, F-92200 Neuilly sur Seine (FR)**
Inventeur: **Cretin, Jacques, 9, avenue de Villars Parly 2, F-78150 Le Chesnay (FR)**
Inventeur: **Lety, Bruno, 95, boulevard Henri Sellier, F-92150 Suresnes (FR)**

(43) Date de publication de la demande: **03.08.83.**
**Bulletin 83/31**

(74) Mandataire: **Congard, Roger-Paul, INSTITUT FRANCAIS DU PETROLE 4, avenue de Bois-Préau, F-92502 Rueil-Malmaison (FR)**

(84) Etats contractants désignés: **AT CH DE GB IT LI NL SE**

(54) **Méthode d'enregistrement et de lecture de séries successives d'échantillons de signaux multiplexés dans un organe de mémorisation unique et dispositif pour sa mise en oeuvre.**

(57)    Système d'enregistrement et de lecture d'échantillons de signaux dans un organe de mémorisation, permettant l'enregistrement d'échantillons prélevés sur un ensemble d'ordre pair de signaux multiplexés au fur et à mesure de la lecture des échantillons correspondant à un ensemble de signaux d'ordre impair précédemment enregistrés.

Les échantillons prélevés respectivement sur tous les signaux des ensembles d'ordre pair et impair sont disposés respectivement aux emplacements d'une première ou d'une seconde série d'emplacements de mémoire bien déterminés, de manière que la lecture des échantillons relatifs à un même signal dans un ensemble d'ordre pair ou impair libère toujours une même suite d'emplacements de la première ou seconde série d'emplacements respectivement, ce qui simplifie l'appareillage requis pour conduire à la fois les opérations d'écriture et de lecture des données et diminue la période de récurrence des ensembles de données à enregistrer.

Application à l'enregistrement d'ensembles de signaux sismiques multiplexés successivement reçus.

ACTORUM AG

- 1 -

METHODE D'ENREGISTREMENT ET DE LECTURE DE SERIES SUCCESSIVES D'ECHANTILLONS
DE SIGNAUX MULTIPLEXES DANS UN ORGANE DE MEMORISATION UNIQUE ET DISPOSITIF
POUR SA MISE EN OEUVRE.

L'invention a pour objet une méthode d'enregistrement de séries successives
d'échantillons de signaux obtenus par multiplexage de signaux distincts,
dans un organe de mémorisation unique adapté à contenir tous les échantillons d'une série, et de lecture des échantillons enregistrés dans cet
organe de mémorisation, permettant un démultiplexage des signaux enregistrés, dans laquelle l'intervalle de temps (d) entre la fin de l'enregistrement d'une série et le début de l'enregistrement de la série suivante
est inférieur à la durée totale de lecture d'une série quelconque, ainsi
qu'un dispositif de mise en oeuvre de la méthode.

La méthode et le dispositif selon l'invention peuvent être utilisés par
exemple pour gérer l'enregistrement de séries successives de données
sismiques dans une mémoire unique, ces séries étant constituées à
partir d'un ensemble de signaux captés par des récepteurs sismiques et
correspondant aux échos sur des couches souterraines d'ondes sismiques
émises par une source acoustique.

A chaque déclenchement de la source d'impulsion ou "tir", on procède à
la réception et à l'enregistrement des ondes reçues pendant un intervalle
de temps suffisant pour recevoir tous les échos susceptibles d'être
réfléchis par des réflecteurs souterrains jusqu'à une profondeur déterminée. Cet enregistrement dure en général plusieurs secondes (de 5 à 10
secondes par exemple).

Les signaux reçus par les récepteurs peuvent être transmis simultanément par un ensemble de fils conducteurs à un système de réception éloigné comportant des moyens de multiplexage et un dispositif d'enregistrement. L'ensemble des récepteurs sismiques peut également être divisé en une pluralité de groupes de récepteurs connectés chacun à un dispositif local d'acquisition de données adapté à collecter, multiplexer et enregistrer les données sismiques recueillies par les récepteurs de chaque groupe. Une fois terminée cette première phase d'acquisition, les dispositifs d'acquisition sont ensuite connectés en séquence au système central de réception et d'enregistrement et lui transmettent les données multiplexées provenant de leurs groupes respectifs de récepteurs, qu'ils ont enregistrées durant la première phase.

En prospection sismique terrestre par exemple où l'intervalle de temps séparant deux tirs successifs n'est pas limité impérativement, on peut enregistrer tous les signaux correspondant à un tir donné sur un bloc de mémorisation unique et ensuite procéder à la lecture des séries d'échantillons successivement mémorisés et à leur démultiplexage, le tir suivant n'étant déclenché qu'une fois le bloc de mémoire entièrement effacé.

En prospection sismique marine où l'intervalle de répétition des tirs sismiques ne peut être étendu à volonté, compte-tenu du déplacement régulier du bateau tractant l'ensemble des récepteurs de signaux le long du profil sismique à étudier, la durée de lecture des informations enregistrées relatives à un tir est en général supérieure audit intervalle de répétition. Lorsque le tir suivant est déclenché, une partie seulement du contenu de la mémoire a été extrait et la série des données relatives au nouveau tir ne peut en général être enregistrée sur la même mémoire du fait que celle-ci n'est pas entièrement disponible.

Pour éviter tout chevauchement des enregistrements, on utilise dans ce cas deux organes de mémorisation distincts, chacun d'eux de capacité suffisante pour contenir l'ensemble des données sismiques relatives à un tir. Pendant que les données relatives au tir suivant sont recueillies et enregistrées dans le second organe, on procède à la lecture et à l'effacement progressif du premier organe. Lorsque celui-ci est entièrement vide, il est de nouveau disponible pour enregistrer une nouvelle série de données. Un des deux organes est affecté à l'enregistrement des tirs pairs, l'autre à l'enregistrement des tirs impairs. L'avantage de cette méthode est d'éviter tout mélange de données, mais sa mise en oeuvre requiert un doublement du dispositif d'enregistrement.

La méthode selon l'invention a pour objet d'organiser l'enregistrement de séries successives d'échantillons de signaux obtenus par multiplexage de signaux distincts, dans un organe de mémorisation unique adapté à contenir tous les échantillons d'une série quelconque, et de lire les échantillons enregistrés dans cet organe de mémorisation pour permettre un démultiplexage des signaux enregistrés, de manière que l'intervalle de temps entre la fin de l'enregistrement d'une série et le début de l'enregistrement de la série suivante soit inférieur à la durée totale de lecture d'une série quelconque, chaque série d'échantillons étant subdivisée en une pluralité de groupes réunissant chacun l'ensemble des échantillons de plusieurs signaux.

Cette méthode comporte l'enregistrement de tous les échantillons successifs des séries d'ordre pair, de manière que les échantillons d'un groupe de même ordre de chacune de ces séries soient enregistrés dans une première partie déterminée de l'organe de mémorisation comportant une suite d'adresses dont les numéros d'ordre sont présélectionnés, suivant une première répartition telle que le démultiplexage des signaux dudit groupe libère entièrement cette première partie de l'organe de mémorisation, la lecture des échantillons contenus dans cette première partie de l'organe de mémorisation, de manière à reconstituer les signaux par démultiplexage, et l'enregistrement dans ladite première partie d'échantillons successifs de la série suivante d'ordre impair, simultanément à la lecture des échantillons du groupe d'ordre suivant de la série précédente d'ordre pair dans une autre partie de l'organe de mémorisation, suivant une seconde répartition telle que, après l'enregistrement complet de la série d'ordre impair, la lecture des échantillons dudit groupe de cette série libère une seconde partie déterminée de l'organe de mémorisation comportant une autre suite d'adresses dont les numéros d'ordre sont également présélectionnés.

- 4 -

L'organe de mémorisation est subdivisé par exemple en une pluralité de zones et de sous-ensembles comportant chacun une suite d'adresses prédéterminées, le nombre de ces zones et le nombre de ces sous-ensembles étant chacun égal au nombre des groupes d'échantillons. Les échantillons d'un groupe de même ordre de deux séries distinctes d'un même ordre (pair par exemple) sont alors rangés dans une même zone de l'organe de mémorisation et les échantillons du groupe de même ordre de deux séries d'ordre différent du premier (impair par exemple) sont rangées dans un même sous-ensemble.

Le regroupement des échantillons de tous les signaux d'un même groupe alternativement dans l'une des deux parties sus-mentionnées de la mémoire qui restent toujours les mêmes, permet d'utiliser un système logique adapté à commander un mode de lecture des échantillons permettant d'effectuer un démultiplexage des signaux, qui est beaucoup plus simple que celui requis lorsque les adresses des échantillons à lire pour effectuer un démultiplexage appartiennent à un grand nombre de suites distinctes d'emplacements différents. Pour la même raison, le système de commande permettant d'enregistrer les nouvelles séries d'échantillons alternativement dans deux parties différentes seulement de l'organe de mémorisation est plus simple à réaliser.

De plus, l'intervalle de temps entre la fin d'un enregistrement d'une série et le début de l'enregistrement de la série suivante est tel que le démultiplexage de tous les signaux d'une série est réalisé antérieurement à l'instant final d'enregistrement des échantillons multiplexés de la série suivante.

Le maintien d'un certain décalage de temps entre le début de la lecture des échantillons d'une série et le début de l'enregistrement de la série suivante, ce décalage de temps étant compatible avec l'intervalle de temps séparant l'arrivée de deux séries quelconques d'échantillons, permet de rendre asynchrones les opérations de lecture et d'écriture des données dans l'organe de mémorisation et par conséquent de simplifier les éléments de synchronisation nécessaires à la conduite des opérations.

- 5 -

D'autres caractéristiques et avantages de la méthode ainsi que les caractéristiques du dispositif de mise en oeuvre apparaîtront à la lecture de la description d'un mode particulier et non limitatif de réalisation de l'invention, en se référant aux dessins annexés sur lesquels :

- la figure 1 représente le chronogramme d'un cycle d'enregistrement des échantillons de signaux multiplexés produits par des récepteurs de signaux ;

- la figure 2 représente schématiquement une méthode connue de rangement d'échantillons multiplexés dans un organe de mémorisation ;

- la figure 3 représente schématiquement la disposition des échantillons successifs des signaux multiplexés en accord avec la méthode selon l'invention, suivant un premier mode de rangement ou de répartition à l'intérieur de l'organe de mémorisation représenté sous la forme d'un tableau pour des raisons de clarté ;

- la figure 4 représente symboliquement l'ordre d'écriture des échantillons successifs dans l'organe de mémorisation suivant le premier mode de rangement ;

- la figure 5 représente symboliquement l'ordre de lecture des échantillons successifs dans l'organe de mémorisation, suivant le premier mode de rangement ;

- la figure 6 représente schématiquement la disposition des échantillons successifs des signaux multiplexés en accord avec la méthode selon l'invention, suivant un second mode de rangement ou de répartition, à l'intérieur de l'organe de mémorisation qui est également représenté sous la forme d'un tableau pour des raisons de clarté ;

- la figure 7 représente symboliquement l'ordre d'écriture des échantillons dans l'organe de mémorisation, suivant le second mode de rangement ou de répartition ;

- 6 -

- la figure 8 représente symboliquement l'ordre de lecture des échantillons rangés dans l'organe de mémorisation, suivant le second mode de rangement ou de répartition ;

- la figure 9 représente la disposition symétrique de sections de l'organe de mémorisation contenant des échantillons prélevés sur les mêmes groupes d'échantillons dans deux séries d'échantillons successivement enregistrés en accord avec la méthode selon l'invention ;.

- la figure 10 représente les chronogrammes des cycles d'enregistrement des séries d'échantillons d'ordre pair et d'ordre impair, et

- la figure 11 représente schématiquement un exemple de réalisation du dispositif de mise en oeuvre de la méthode selon l'invention.

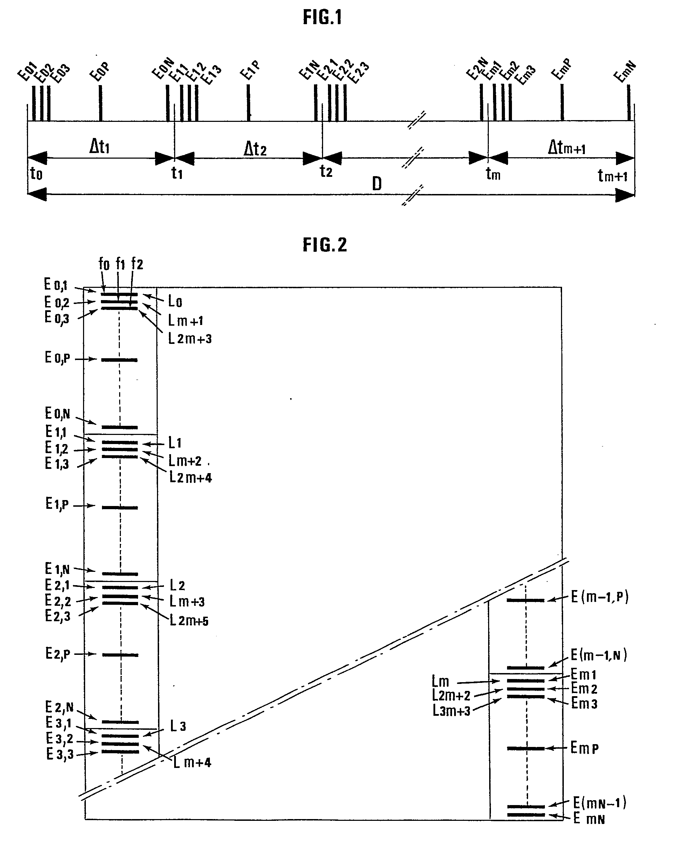

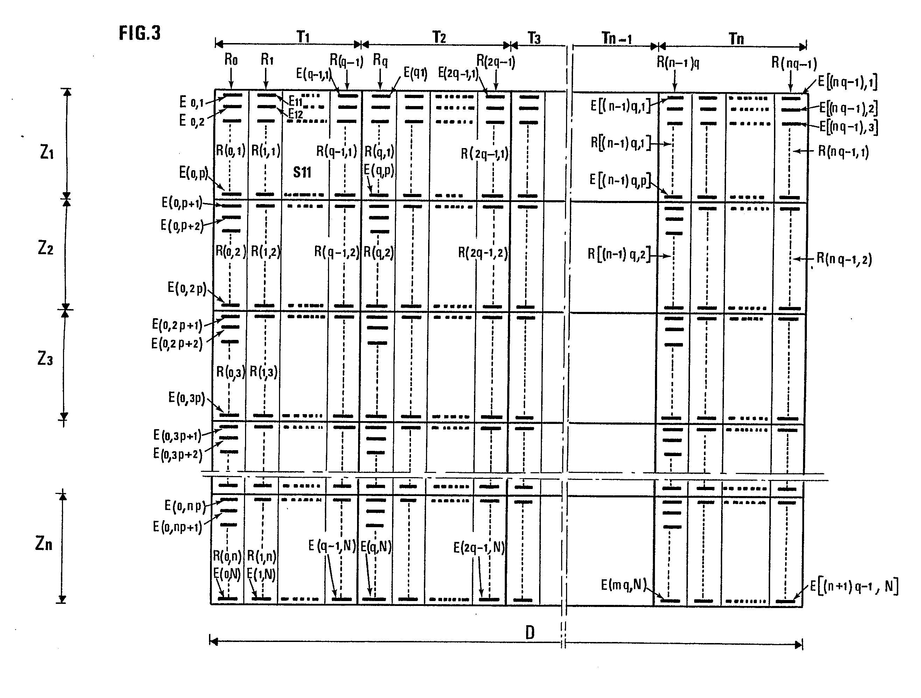

Le cycle d'enregistrement dont le chronogramme est représenté à la figure 1 comporte l'échantillonnage des signaux produits par N récepteurs de signaux sismiques, constitués chacun, de manière connue, d'un capteur ou d'un groupe de capteurs interconnectés, adaptés à délivrer un signal unique, et leur multiplexage. Le cycle de durée totale D est subdivisé en un certain nombre $m + 1$ d'intervalles de temps élémentaires ($\Delta t1$, $\Delta t2...\Delta tm + 1$) de durée $\Delta t$.

A partir de l'instant initial t0 et durant le premier intervalle de temps $\Delta t1$, un premier échantillon E01, E02...E0P...E0N est prélevé sur chacun des N signaux produits par les N récepteurs et, par multiplexage, ces N premiers échantillons sont successivement transmis et enregistrés. Puis, à partir de l'instant suivant t1 et durant le second intervalle de temps $\Delta t2$, un second échantillon E11, E12, E13, E1P... E1N est prélevé sur chacun des N signaux. Par multiplexage également, ces N seconds échantillons sont transmis et enregistrés. Le même processus d'échantillonnage et de multiplexage se reproduit successivement pour tous les échantillons suivants et le cycle s'achève par un dernier intervalle de temps $\Delta tm + 1$ commençant à un instant tm, pendant lequel est transmise et enregistrée une dernière série d'échantillons Em1, Em2, Em3...EmP...EmN correspondant au $m^{ième}$ échantillon prélevé successivement sur les N signaux reçus.

Une méthode connue d'enregistrement de ces m séries successives de N échantillons consiste à introduire en séquence les mots numériques correspondant aux amplitudes des échantillons, aux différents emplacements d'un bloc de mémoire ou organe de mémorisation symbolisés par des traits f0, f1, f2, etc... (Fig. 2).

On mémorise la première série E01, E02...E0P...E0N, puis la seconde E11, E12...E1P...E1N, et ainsi de suite jusqu'à la dernière série Em1, Em2... EmP...EmN.

Une fois l'enregistrement terminé, on procède au démultiplexage des échantillons, en lisant successivement dans le bloc de mémorisation les échantillons L0, L1, L2...Lm, correspondant respectivement aux échantillons enregistrés E01, E11, E21, E31...Em1 prélevés en séquence sur le premier signal reçu.

Ensuite, on lit successivement les échantillons Lm + 1, Lm + 2... L2m + 2 correspondant respectivement aux échantillons enregistrés E02, E12, E22, E32... Em2, prélevés en séquence sur le second signal reçu. De la même manière, on regroupe par la lecture de la mémoire les échantillons L2m + 3 à L3m + 3, correspondant respectivement aux échantillons enregistrés E03, E13, E23...Em3, prélevés sur le troisième signal reçu et ainsi de suite jusqu'au $N^{ième}$ signal sismique.

On voit sur la figure 2 que si le bloc de mémoire ne possède pas d'organisation particulière, le pas de lecture (temps d'accès à un emplacement de mémoire repéré par son adresse à partir de l'emplacement précédent) est plus élevé que le pas d'écriture, car les emplacements de mémoire libérés par la lecture séquentielle des mots L0, L1, L2, etc... sont dispersés dans tout le bloc. On voit également qu'en l'absence d'organisation particulière, tout enregistrement d'une nouvelle série d'échantillons effectuée avant la fin du cycle de lecture en cours conduit à disperser les échantillons de cette nouvelle série aux emplacements libérés et que l'ensemble des emplacements qui sera libéré ultérieurement par le démultiplexage des signaux de la nouvelle série sera totalement distinct des précédents. Il en résulte que le dispositif adapté à gérer une telle mémoire est nécessairement très complexe ce qui rend difficilement applicable la solution d'un bloc de mémorisation unique pour enregistrer des séries de données récurrentes.

La méthode d'enregistrement et de lecture décrite ci-après, permet d'éviter cet effet de dispersion des adresses de lecture et de commencer un nouvel enregistrement après une libération seulement partielle de l'organe de mémorisation.

Si le dispositif de réception comporte N récepteurs répartis en n groupes G1, G2...Gn (N = 256 et n = 16 par exemple) transmettant des signaux à enregistrer pendant un intervalle de temps D (6 secondes par exemple), on délimite, à l'intérieur de l'organe de mémorisation ou bloc de mémoire n sous-ensemble (T1, T2...Tn) constitués chacun d'une pluralité d'adresses bien définies, adaptés à contenir tous les échantillons successifs des signaux engendrés par les N récepteurs respectivement pendant n intervalles de temps $\Delta t1$, $\Delta t2...\Delta tn$ de durée $\Delta t = \frac{D}{n}$ . Le nombre d'échantillons contenus dans chaque sous-ensemble (T1...Tn) dépend de la période d'échantillonnage de chacun des signaux.

Si $\tau$ est cette période, le nombre q d'échantillons différents prélevés sur chaque signal et contenus dans un sous-ensemble quelconque sera égal à $\frac{D}{n\tau}$ et le nombre total d'échantillons contenus dans chaque sous-ensemble sera égal à $\frac{DN}{\tau n}$ .

De plus, on délimite à l'intérieur de chaque sous-ensemble (T1...Tn) un nombre q de piles d'emplacements de mémoire (R0, R1...Rq-1) (Rq...R2q-1) etc... dont les adresses sont bien définies, ces piles juxtaposées sur le tableau représentatif du bloc de mémorisation étant adaptées chacune à contenir N échantillons de même ordre prélevés successivement sur N signaux différents à enregistrer issus des N récepteurs, et chacun de ces sous-ensembles étant adaptés à contenir q échantillons prélevés sur les N signaux.

Si l'on se fixe les valeurs numériques suivantes : N = 256, D = 6s, n = 16, t = 1ms, on vérifie immédiatement que chaque pile est adaptée à contenir les 256 échantillons ayant le même numéro d'ordre dans des différents signaux, que chaque sous-ensemble comporte 375 piles adaptées à contenir tous les échantillons prélevés et que l'ensemble du bloc de mémoire a une capacité au moins égale à 256.000 échantillons à chaque seconde soit un total de $1.536.10^6$ emplacements de mémoire.

On subdivise chaque pile (R0, R1, etc...) en n parties égales (le nombre de ces parties étant égal au nombre de sous-ensembles) contenant chacune les emplacements pour la mémorisation d'un certain nombre p d'échantillons de même rang prélevés sur p signaux différents parmi les N. Les parties correspondantes de toutes les piles de la mémoire constituent des zones $Z_1$, $Z_2$...Zn. L'intersection d'une zone et d'un sous-ensemble constitue une section S. On désigne par exemple par S1,1 l'intersection de la zone Z1 avec le sous-ensemble T1.

Pour reprendre l'exemple numérique précédent, on peut subdiviser les 256 récepteurs du dispositif de réception en 16 groupes (G1, G2...G16) de 16 récepteurs et constituer 16 zones différentes dans le bloc de mémoire, chacune d'elle pouvant contenir 6.000 échantillons de chaque sous-ensemble soit 96.000 échantillons au total.

La répartition des échantillons à l'intérieur de l'organe de mémorisation ou bloc de mémoire est différente pour l'enregistrement et la lecture des séries d'échantillons quelconques d'ordre pair et des séries d'échantillons quelconques d'ordre impair, correspondant à des tirs sismiques successivement d'ordre pair et impair.

Séries d'ordre pair :

Le bloc de mémoire étant ainsi constitué, on procède à l'enregistrement de tous les échantillons issus des N récepteurs pendant l'intervalle de temps D avec la période d'échantillonnage $\Delta t$ suivant un premier mode de répartition décrit ci-après. Dans la première pile Ro du premier sous-ensemble T1 (Fig. 3) on introduit les échantillons ayant le numéro d'ordre o prélevés successivement sur N signaux différents issus des N récepteurs, soit : E01, E02...E0N, les différentes sections R0,1, R0,2...R0,n, de la pile R0 contenant chacune p échantillons. Puis on introduit, dans la pile adjacente R1 du premier sous-ensemble du tableau représentatif, les échantillons ayant le numéro d'ordre 1, prélevés successivement sur les N signaux différents soit : E11, E12...E1N, chaque section R1,1, R1,2...R1,n de cette pile comportant également p échantillons.

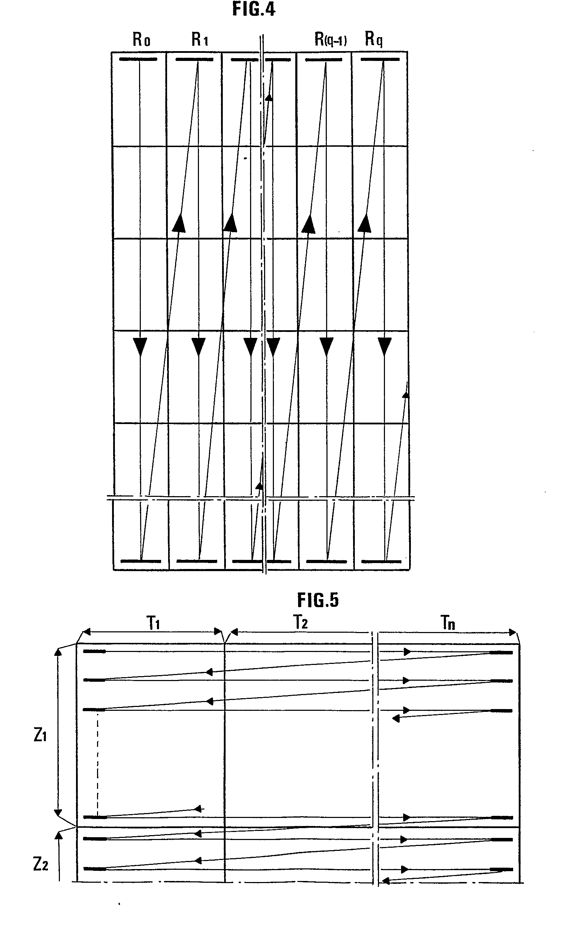

On répète les mêmes opérations pour toutes les piles suivantes R2...R(q - 1) du sous-ensemble T1 puis on procède de manière identique au chargement des piles Rq à R(2q - 1) du sous-ensemble T2 et successivement à celles des sous-ensembles T3 à Tn. Le mode d'écriture choisi est symbolisé sur la figure 4.

L'enregistrement étant terminé, on procède alors à la lecture et au démultiplexage des échantillons en regroupant tous les échantillons relatifs à un même signal. Pour reconstituer le premier signal par exemple, on lit successivement les échantillons E01, E11, E21...E(q - 1,1), E(q,1)... E(2q - 1,1) à la première ligne des différentes piles des sous-ensembles T1, T2, puis ceux disposés à la première ligne des différentes piles des sous-ensembles suivants T3 à Tn - 1, puis enfin les échantillons E((n - 1)q,1) à E((nq - 1),1) en tête des piles R(n - 1)q à R(nq - 1) du sous-ensemble Tn, qui ont été prélevés en séquence sur le premier signal pendant la phase d'enregistrement précédente. De la même manière on lit et on juxtapose les échantillons correspondant : E0,2, E1,2..E((nq-1),2) pour reconstituer le second signal, les échantillons E0,3, E1,3... E((nq - 1),3) pour reconstituer le troisième signal, etc... jusqu'à la fin de l'étape de lecture où tous les N signaux enregistrés sont reconstitués.

On remarque que, compte tenu du mode choisi d'organisation du tableau représentatif du bloc de mémoire, les échantillons successifs d'un même signal se retrouvent sur une même ligne et que, contrairement au cas général décrit en se référant à la figure 1, le démultiplexage d'un signal enregistré libère complètement une suite d'emplacements juxtaposés du tableau représentant l'organe de mémorisation.

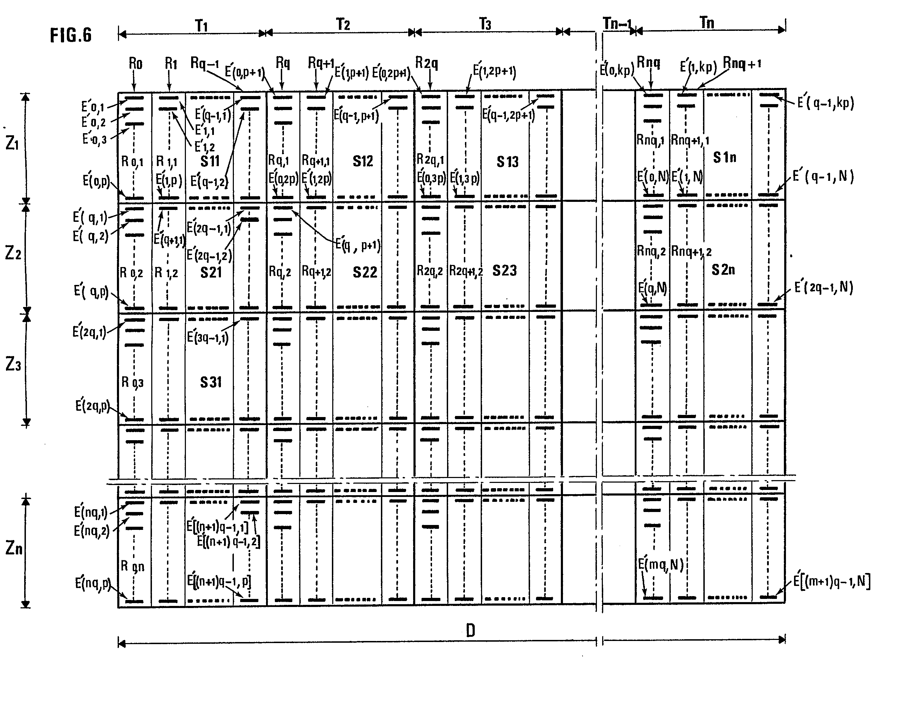

Le démultiplexage des signaux enregistrés s'effectue par une lecture ligne par ligne du tableau représentant le contenu de la mémoire (mode de lecture symbolisé à la figure 5).

Lorsque les p premiers signaux produits par le premier groupe G1 de p récepteurs parmi les N ont été lus et démultiplexés, la première zone $Z_1$ est entièrement vide et se trouve disponible pour un nouveau cycle d'enregistrement d'échantillons de signaux multiplexés.

On procède à un nouveau tir sismique d'ordre impair de manière que les premiers ensembles d'échantillons obtenus par multiplexage des nouveaux signaux soient disponibles dès que la première zone $Z_1$ est libérée.

Série suivante d'ordre impair :

On effectue un rangement des premières séquences d'échantillons disponibles dans la première zone évacuée $Z_1$ suivant un second mode de répartition décrit ci-après et représenté à la figure 6.

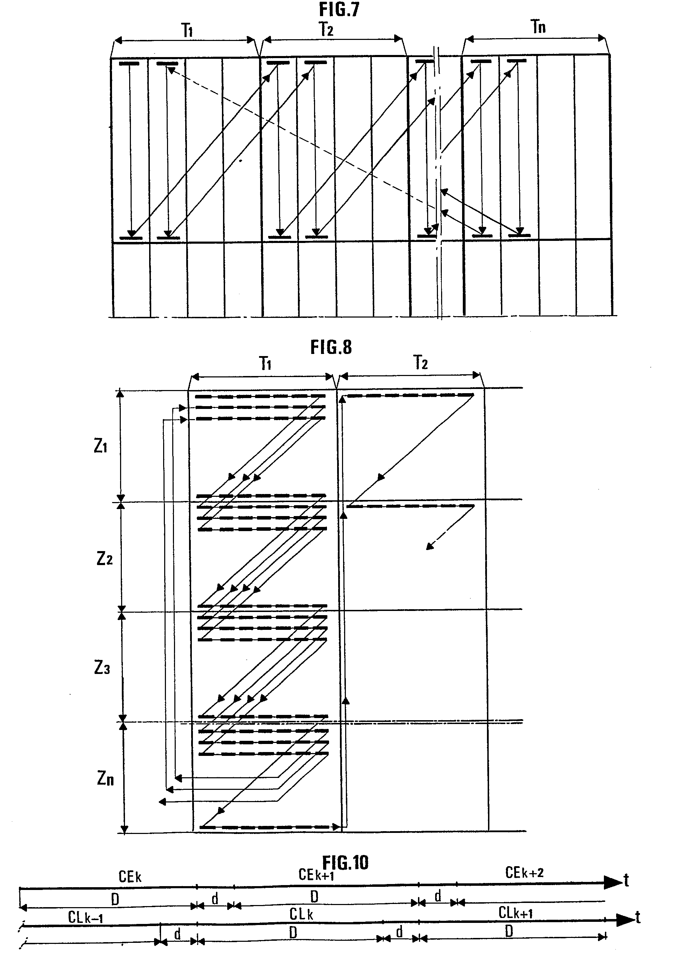

Dans la partie disponible R01 du premier sous-ensemble T1, section S11, on enregistre le premier échantillon E'0,1, E'0,2...E'0,p des p premiers signaux, les premiers échantillons des p signaux suivants : E'(0,p + 1), E'(0,p + 2)...E'(0,2p) sont enregistrés dans la partie disponible R(q,1) de la première pile Rq du second sous-ensemble T2 (section S12). De la même manière, les échantillons des signaux E'(0,2p + 1) à E'(0,3p) sont rangés dans la partie disponible R(2q,1) de la première pile R2q du troisième sous-ensemble T3 (section S13). L'opération se poursuit jusqu'à ce que les N sections constitutives de la première séquence d'échantillons prélevés sur les différents signaux soient enregistrés. Le second mode de répartition des échantillons dans l'organe de mémorisation est représenté symboliquement à la figure 7 par des flèches.

Une fois la première séquence d'échantillons enregistrée, on procède à l'enregistrement de la deuxième séquence d'échantillons obtenue par un nouveau multiplexage des signaux en accord avec le même mode d'enregistrement. Les seconds échantillons des p premiers signaux E'1,1 à E'1,p

sont rangés dans la partie disponible R1,1 de la seconde pile R1 du premier sous-ensemble T1 (section S11), ceux des p signaux suivants E'(1,p + 1) à E'(1,2p) sont rangés dans la partie disponible R(q + 1,1) de la deuxième pile R(q + 1) (section S12) du second sous-ensemble T2 (Fig. 6) et ainsi de suite jusqu'au dernier groupe de p échantillons E'(1,kp) à E'(1,N) qui sont rangés dans la section disponible R(nq + 1,1) de la seconde pile Rnq + 1 du dernier sous-ensemble Tn (section S1n). On procède de la même manière à l'enregistrement des autres séries d'échantillons prélevés pendant le premier intervalle de temps $\Delta$tn d'enregistrement.

A l'issue de cet intervalle, la première zone disponible Z1 est entièrement occupée.

Durant le déroulement de cette phase d'enregistrement, on a procédé au démultiplexage des signaux d'ordre p + 1 à 2p (groupe G2), enregistrés au cours du cycle précédent dans la seconde zone $Z_2$ de la mémoire suivant le mode de lecture symbolisé à la figure 5 et précédemment mentionné. Lorsque les p signaux de la seconde zone $Z_2$ ont été lus et reconstitués, celle-ci se trouve disponible pour l'enregistrement des échantillons obtenus en multiplexant les N signaux reçus durant le second intervalle de temps $t2 = \dfrac{D}{n}$ de réception.

On procède alors à l'enregistrement des échantillons d'ordre q prélevés sur les signaux en remplissant comme précédemment la nouvelle partie disponible R02 de la première pile R0 du premier sous-ensemble T1 (section S21) puis celles R(q,2), R(2q,2)...R(nq,2) de la première pile des sous-ensembles suivants T2, T3...Tn (section S22...S2n) et l'on enchaîne en remplissant les emplacements de mémoire des parties disponibles R1,2, R(q + 1,2)...R(nq + 1,2) de la seconde pile des sections S21, S22...S2n puis des parties correspondantes de la troisième pile de chaque sous-ensemble etc... jusqu'à la pile d'ordre q-1 avec respectivement les échantillons d'ordre q + 1, q + 2...2q - 1 de tous les signaux.

A la fin de l'enregistrement de cette seconde série dans la seconde zone $Z_2$, la troisième zone $Z_3$ de l'organe de mémorisation, qui a été libérée par démultiplexage des signaux d'ordre $2p + 1$ à $3p$ de la série d'ordre pair précédente (groupe G3), se trouve disponible également et la phase d'enregistrement des échantillons suivants peut être effectuée.

Le cycle d'enregistrement se poursuit et les zones successivement libérées sont remplies au fur et à mesure par les échantillons. On procède alors aux démultiplexages successifs des $p$ premiers signaux enregistrés de cette nouvelle série d'ordre impair.

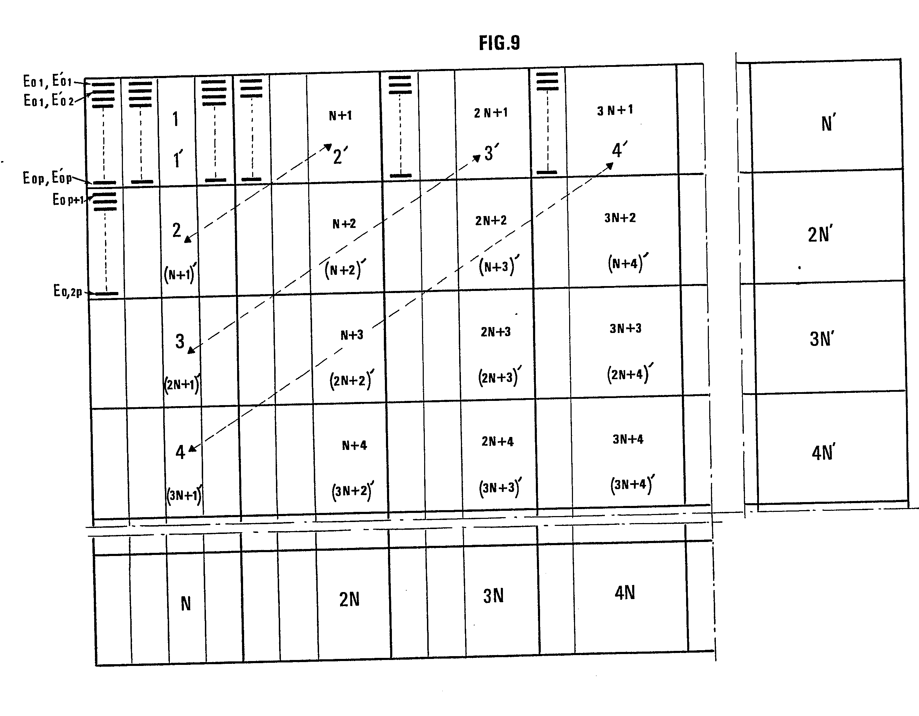

Pour reconstituer le premier signal on lit successivement les échantillons $E'0,1$, $E'1,1$ à $E'(q - 1,1)$, $E'(q,1)$ à $E'(2q - 1,1)$...$E'(nq,1)$ à $E'(n + 1)q - 1,1)$. le second signal est obtenu en lisant les échantillons $E'02$ à $E'(q - 1,2)$, $E'(q,2)$ à $E'(2q - 1,2)$, $E'(nq,2)$ à $E'((n + 1)q - 1,2)$ etc... Compte tenu de l'ordre de rangement adopté pour les échantillons, on voit que tous les échantillons des $p$ premiers signaux se trouvent regroupés dans le premier sous-ensemble T1 et que, à l'issue des opérations de lecture et de reconstitution de ces $p$ premiers signaux effectuées en respectant l'ordre de lecture symbolisé à la figure 8, le sous-ensemble T1 est entièrement libéré et disponible pour le stockage de nouvelles séries d'échantillons.

On peut alors procéder à un cycle d'enregistrement d'une nouvelle série d'ordre pair en remplissant les emplacements de premier sous-ensemble T1 selon le premier mode de répartition symbolisé à la figure 4, puis des sous-ensembles T2, T3...Tn au fur et à mesure qu'ils sont libérés par le démultiplexage des signaux enregistrés au cours du cycle précédent.

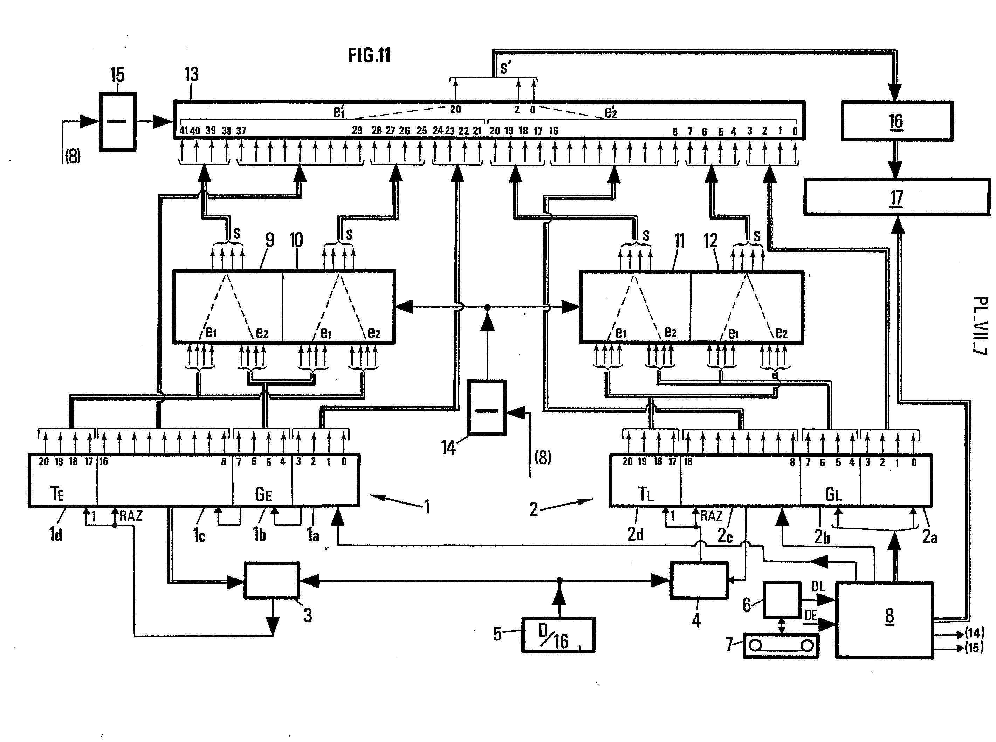

Les cycles d'enregistrement des séries d'échantillons suivantes sont effectués alternativement suivant le premier et le second mode de répartition décrits ci-dessus, ce qui permet de réduire l'intervalle de temps entre deux tirs sismiques à une valeur toujours inférieure à la durée d'enregistrement ou de lecture de la totalité de la mémoire. Un intervalle de temps constant d sépare les cycles d'enregistrement successif CEk, CEk + 1, CEk + 2, etc... (Fig. 10). Les cycles de lecture correspondants CLk, CLk + 1, etc... sont également séparés par un même intervalle de temps d et commencent respectivement à la fin des cycles CEk, CEk + 1... Quelles que soient les valeurs choisies pour la durée (D) des cycles d'enregistrement et celle des intervalles d entre les tirs sismiques successifs, la méthode d'enregistrement décrite ci-dessus peut être mise en oeuvre si l'on s'impose par exemple comme condition que : $a \geqslant \frac{d}{D}$, a représentant la fraction du contenu de la mémoire lue pendant l'intervalle de temps d.

Sur la figure 9, où les sections de la mémoire successivement écrites suivant le premier mode de répartition sont référencées 1, 2, 3, etc... et celles écrites suivant le second mode de répartition sont référencées 1', 2', 3', etc..., on voit que les sections correspondantes contenant les échantillons de même numéro d'ordre dans deux cycles d'enregistrement successifs sont disposées symétriquement et que les emplacements de chacune d'elles sur le tableau représentant la mémoire, suivant l'un ou l'autre des deux modes de répartition sur ce tableau se déduisent l'un de l'autre en intervertissant les sous-ensembles verticaux et les zones horizontales et vice-versa ou autrement dit en intervertissant les lignes et les colonnes de la mémoire.

Le dispositif de mise en oeuvre décrit ci-après permet de changer alternativement le mode de répartition des échantillons de la mémoire et d'intervertir les ensembles d'emplacements de mémoire, de manière à respecter alternativement le premier et le second modes de répartition des échantillons.

Le dispositif de mise en oeuvre représenté à la figure 11 est adapté au cas pratique où le nombre N de récepteurs ou de groupes de récepteurs fournissant des signaux distincts est égal à 256, avec une durée totale d'enregistrement choisie égale à 6.144 ms et divisée en 16 intervalles ou tranches $\Delta t1$, $\Delta t2$...$\Delta t16$ de 384ms chacun, la période d'échantillonnage de tous les signaux distincts étant égale à 1ms.

Les 256 récepteurs sont répartis en 16 groupes comportant chacun 16 récepteurs ou groupes de récepteurs produisant 16 signaux distincts et donc 16 traces d'enregistrement.

- 15 -

L'organe de mémorisation est subdivisé en seize sous-ensembles Tl à Tl6, constitués chacun d'une pluralité d'adresses de mémoire prédéterminées.

Le dispositif comporte deux registres 1,2 à 21 bits, chacun d'eux étant subdivisé en quatre sections.

Une première section la, 2a, constituée par les bits de poids 0 à 3 est affectée à la mémorisation du numéro du récepteur ou du signal qu'il produit à l'intérieur de chaque groupe de seize récepteurs, une seconde section lb, 2b, constituée par les bits de poids 4-7 est affectée à la mémorisation du numéro d'un groupe de récepteurs parmi les seize groupes Gl, G2...G16, la troisième section lc, 2c, constituée par les bits de poids 8 à 16, est affectée à la mémorisation du nombre de millisecondes écoulées depuis le début de chaque tranche de temps $\Delta$tl, $\Delta$t2, $\Delta$tl6 ou du numéro d'ordre des échantillons à l'intérieur de celle-ci, et la quatrième section ld, 2d, constituée par les bits de poids 17 à 20, est affectée à la mémorisation du numéro d'ordre des tranches à l'intérieur de l'ensemble des seize tranches de temps $\Delta$tl, $\Delta$t2... $\Delta$tl6.

Les contenus des sections lc, 2c, affectées à la mesure de temps écoulé sont comparés respectivement dans deux comparateurs 3,4 avec le contenu d'un élément de mémorisation 5 où est enregistrée la valeur numérique en millisecondes de la durée de chaque tranche de temps, soit 384 ms. A la détection de l'égalité, les comparateurs 3,4 engendrent des impulsions utilisées pour incrémenter respectivement les sections ld, 2d et remettre à zéro les sections lc et 2c. Les impulsions de débordement successives engendrées par les sections la et lb sont utilisées respectivement pour incrémenter les sections lb et lc.

Le dispositif comporte un ensemble de logique 6 commandé par un élément de mémorisation tel qu'un dérouleur de bande magnétique 7 par exemple et un système électronique de gestion 8 adapté :

- à établir des priorités entre les signaux correspondant à des demandes DE d'écriture (d'enregistrement) qu'il reçoit d'un dispositif central de synchronisation des opérations d'acquisition de données (non représenté), et ceux correspondant à des demandes de lecture DL qui lui sont transmis par l'ensemble de logique 6 sur commande du dérouleur de bande 7 ; et

- à incrémenter la section 2c du registre 2 sur commande de l'ensemble de logique 6, à introduire dans les sections 2a, 2b, du registre 2 le numéro d'un récepteur (ou de la trace d'enregistrement qu'il engendre) parmi les 256 récepteurs ou traces disponibles, et à engendrer des impulsions pour incrémenter la section 1a du registre 1.

L'ensemble permettant l'interversion des sous-ensembles verticaux et des zones horizontales de la mémoire est constitué par :

- des moyens de commutation comportant :

a) deux multiplexeurs 9, 10 pourvus chacun d'un premier groupe de quatre entrées e1 et d'un second groupe de quatre entrées e2, et de quatre sorties S. Chaque multiplexeur est adapté à connecter respectivement les quatre sorties S aux entrées du premier groupe e1 ou aux entrées du second groupe e2. Les quatre entrées du premier groupe e1 du multiplexeur 9 et du second groupe e2 du multiplexeur 10 sont connectées aux quatre sorties de la section 1d du registre 1. De même les quatre entrées du second groupe e2 du multiplexeur 9 et du premier groupe e1 du multiplexeur 10 sont connectées aux quatre sorties de la section 1b du registre 1 ;

b) deux multiplexeurs 11, 12 identiques aux multiplexeurs 9, 10. Les quatre entrées du premier groupe e1 du multiplexeur 11 et celles du second groupe du multiplexeur 12 sont connectées aux quatre sorties de la section 2d du registre 2. De même, les quatre entrées du second groupe e2 du multiplexeur 11 et celles du premier groupe du multiplexeur 12 sont connectées aux quatre sorties de la section 2b du registre 2 ;

- des moyens de sélection constitués d'un multiplexeur d'adresses 13 à 42 entrées réparties en deux groupes e'1, e'2 de 21 entrées, et 21 sorties S'. Ce multiplexeur est adapté à connecter respectivement les 21 sorties S' aux 21 entrées du groupe e'1, ou bien aux 21 entrées du groupe e'2 en fonction d'un signal de commande. Les entrées 0 à 3, 8 à 16, d'une part, et 21 à 24 et 29 à 37 d'autre part du multiplexeur 13 sont respectivement connectées aux sorties 0 à 3 et 8 à 16 du registre 2 (sections 2a et 2c) d'une part et aux sorties 0 à 3 et 8 à 16 du registre 1 (sections 1a à 1c) d'autre part. Les entrées 4 à 7 d'une part et 17 à 20 d'autre part du multiplexeur 13 sont respectivement connectées aux quatre sorties S du multiplexeur 12 d'une part et à celles du multiplexeur 11 d'autre part.

Les quatre entrées 25 à 28 d'une part et 38 à 41 d'autre part du multiplexeur 13 sont connectées respectivement aux quatre sorties S du multiplexeur 10 d'une part et à celles du multiplexeur 9 d'autre part.

Les 21 sorties 0 à 20 du multiplexeur 13 sont connectées aux entrées d'un élément de décodage d'adresses 16 adapté à commander l'écriture ou la lecture de données dans l'organe de mémorisation 17 organisé de la manière indiquée dans la description de la méthode selon l'invention, à des emplacements définis par les mots binaires appliqués respectivement aux entrées e'1 ou aux entrées e'2 du multiplexeur 13 ;

- un basculeur bistable 14 dont l'une des sorties est connectée à l'entrée de commande des multiplexeurs 9, 10, 11, 12 et dont une des entrées est connectée au système de gestion 8 ; et

- un basculeur bistable 15 dont l'une des sorties est connectée à l'entrée de commande du multiplexeur 13 et dont l'une des entrées est également connectée au système de gestion 8.

Le dispositif fonctionne de la manière suivante :

Chaque cycle d'enregistrement d'une série d'échantillons comporte l'introduction dans la section 1a du registre 1 d'impulsions d'incrémentation produites par le système de gestion 8. Toutes les seize impulsions, la section 1a engendre une impulsion de débordement qui est comptabilisée dans la section 1b du registre 1. De la même manière, lorsque la section

1b du registre 1 a comptabilisé seize impulsions successives, c'est-à-dire toutes les millisecondes (intervalle requis pour prélever un échantillon sur toutes les traces différentes d'enregistrement), une impulsion de débordement est introduite dans la section 1c du registre. Les impulsions de débordement successives incrémentent d'une unité le contenu de la section 1c du registre 1.

A intervalles de temps réguliers de 384 millisecondes (intervalle de temps requis pour prélever 384 échantillons distincts sur chacune des 256 traces d'enregistrement et les mémoriser dans un des sous-ensembles T1, T2...T16 de l'organe de mémorisation 17), le comparateur 3, adapté à effectuer une comparaison entre le nombre affiché par la section 1c et le nombre mémorisé dans l'élément 5, détecte l'égalité et engendre une impulsion utilisée pour la remise à zéro de la section 1c et l'incrémentation d'une unité de la section 1d du registre 1. Quand la section 1d a comptabilisé 16 impulsions définissant un intervalle de temps global d'enregistrement de 6.144 ms, le cycle d'enregistrement de la série d'échantillons est terminé.

A chaque cycle d'écriture des échantillons d'une série d'ordre impair par exemple, le système de gestion 8, à la réception d'un signal DE, commande l'activation du basculeur bistable 14 de manière que les sorties 4 à 7 de la section 1b d'une part et les sorties 17 à 20 de la section 1d d'autre part, soient respectivement connectées aux entrées 25 à 28 du multiplexeur 13 d'une part et aux entrées 38 à 41 d'autre part, de ce même multiplexeur. A chaque cycle d'écriture d'une série paire d'échantillons par exemple, la commutation des multiplexeurs 9, 10 permet d'inverser les connexions précédentes. Les sorties 4 à 7 de la section 1b sont alors connectées aux entrées 38 à 41 du multiplexeur 13 et les sorties 17 à 20 sont connectées aux entrées 25 à 28 de ce même multiplexeur, cette interversion assurant la substitution recherchée du contenu des sections de la mémoire d'une étape d'enregistrement à la suivante.

Chaque étape de lecture comporte l'introduction en séquence dans les sections 2a, 2b du registre des différents numéros des récepteurs (ou des traces d'enregistrement qu'ils engendrent) dont il s'agit de lire les échantillons successifs et l'incrémentation de la section 2c du registre 2 ordonnée par le système de gestion 8 sur commande de l'ensemble de logique 6, à un rythme dépendant du temps d'accès du dérouleur de bande 7, jusqu'à la détection par le comparateur 4 de l'égalité entre le nombre contenu dans la section 2c du registre 2 et le nombre prédéterminé mémorisé dans l'élément 5, qui provoque la remise à zéro du contenu de cette section et l'incrémentation de la section 2d.

A chaque étape de lecture d'une série d'ordre impair par exemple, le système de gestion 8 commande l'activation du basculeur bistable 14, de manière que les sorties 4 à 7 de la section 2b du registre 2 d'une part et les sorties 17 à 20 de la section 2d de ce même registre soient respectivement connectées aux entrées 4 à 7 d'une part et aux entrées 17 à 20 d'autre part du multiplexeur 13. A chaque étape de lecture d'une série d'ordre pair par exemple, la commutation des multiplexeurs 11, 12 permet d'inverser les connexions précédentes, les sorties 4 à 7 de la section 2b du registre 2 d'une part et les sorties 17 à 20 de la section 2d du même registre d'autre part, étant respectivement connectées aux entrées 17 à 20 et aux entrées 4 à 7 du multiplexeur 13. De la même manière, cette interversion assure la substitution recherchée des contenus des sections de l'organe de mémorisation d'un cycle de lecture au suivant.

Le multiplexeur 13 est actionné par le basculeur 15 lorsque, ayant effectué la lecture des signaux d'une zone ou d'un sous-ensemble de l'organe de mémorisation, on doit procéder simultanément à l'enregistrement des échantillons multiplexés d'une série et à la lecture et au démultiplexage des échantillons de la série précédente. Sur commande du système de gestion 8 qui actionne le basculeur 15, les sorties du multiplexeur 13 sont commutées sur les entrées e'1 de manière à transférer dans l'élément de décodage 16 une adresse d'écriture mémorisée dans le registre 1 ou aux entrées e'2, de manière à transférer dans ledit élément une adresse de lecture mémorisée dans le registre 2.

0084746

- 1 -

<u>R E V E N D I C A T I O N S</u>

1. - Méthode d'enregistrement de séries successives d'échantillons de signaux obtenus par multiplexage de signaux distincts dans un organe de mémorisation unique adapté à contenir tous les échantillons d'une série, et de lecture des échantillons enregistrés dans cet organe de mémorisation, permettant un démultiplexage des signaux enregistrés, dans laquelle l'intervalle de temps (d) entre la fin de l'enregistrement d'une série et le début de l'enregistrement de la série suivante est inférieur à la durée totale de lecture d'une série quelconque et dans laquelle la série des échantillons est subdivisée en une pluralité de groupes (G1, G2...) réunissant chacun l'ensemble des échantillons de plusieurs signaux, caractérisée en ce qu'elle comporte :

- l'enregistrement de tous les échantillons successifs des séries d'ordre pair, de manière que les échantillons d'un groupe de même ordre (Gi) de chacune de ces séries soient enregistrés dans une première partie déterminée de l'organe de mémorisation comportant une suite d'adresses dont les numéros d'ordre sont présélectionnés, suivant une première répartition telle que le démultiplexage des signaux dudit groupe libère entièrement cette première partie de l'organe de mémorisation.

- la lecture des échantillons contenus dans cette première partie de l'organe de mémorisation de manière à reconstituer les signaux par démultiplexage, et

- l'enregistrement dans ladite première partie d'échantillons successifs de la série suivante d'ordre impair, simultanément à la lecture des échantillons du groupe d'ordre suivant (Gi + 1) de la série précédente d'ordre pair dans une autre partie de l'organe de mémorisation, suivant une seconde répartition telle que, après l'enregistrement complet de la série d'ordre impair, la lecture des échantillons du groupe (Gi) de cette série libère une seconde partie déterminée de l'organe de mémorisation comportant une autre suite d'adresses dont les numéros d'ordre sont également présélectionnés.

- 2 -

2. - Méthode selon la revendication 1, caractérisée en ce que l'organe de mémorisation est subdivisée en une pluralité de zones de mémoire ($Z_1$, $Z_2$...$Z_n$) et de sous-ensembles de mémoire (T1, T2...Tn) comportant chacun une suite d'adresses déterminées, le nombre de ces zones et le nombre de ces sous-ensembles étant chacun égal au nombre des groupes d'échantillons et en ce que les échantillons d'un groupe de même ordre de deux séries distinctes d'un même ordre (pair par exemple) sont rangés dans une même zone de l'organe de mémorisation, les échantillons du groupe de même ordre de deux séries d'ordre différent du premier (impair par exemple) étant rangés dans un même sous-ensemble.

3. - Méthode selon la revendication 1, caractérisée en ce que ledit intervalle de temps (d) est choisi égal à la durée de lecture par démultiplexage des échantillons d'un groupe.

4. - Méthode selon la revendication 1, caractérisée en ce que la série des échantillons est divisée en autant de groupes qu'il y a de signaux distincts, les vitesses d'enregistrement et de lecture des échantillons dans l'organe de mémorisation étant maintenues sensiblement égales.

5. - Méthode selon la revendication 1, caractérisée en ce que ledit intervalle de temps (d) étant égal à la $n^{ième}$ partie de la durée d'enregistrement d'une série quelconque, on subdivise l'ensemble des échantillons en n groupes, l'organe de mémorisation étant subdivisé en n zones et n sous-ensembles et les échantillons d'un groupe de même ordre des séries d'ordre pair et des séries d'ordre impair respectivement étant rangés dans une même zone ou un même sous-ensemble.

6. - Dispositif pour la mise en oeuvre de la méthode selon la revendication 2, caractérisé en ce qu'il comporte un premier registre (1), et un second registre (2) adaptés à contenir sous forme codée les adresses des emplacements de l'organe de mémorisation (17), le premier registre et le second registre étant affectés à la désignation des adresses dudit organe respectivement pour l'écriture et pour la lecture, les deux registres comportant chacun une première partie (1a, 2a) définissant le numéro du sous-groupe des échantillons correspondant à chaque signal parmi les échantillons de

0084746

- 3 -

son groupe, une seconde partie (1b, 2b) définissant le numéro de chaque groupe d'échantillons, une troisième partie (1c, 2c) définissant une succession d'instants d'accès aux emplacements de l'organe de mémorisation (17) et une quatrième partie (1d, 2d) définissant le numéro d'ordre des sous-ensembles (T1, T2...Tn) dudit organe de mémorisation, des moyens (3, 4, 5) pour incrémenter la quatrième partie (1d, 2d) des deux registres et remettre à zéro les contenus de leurs troisièmes parties (1c, 2c) en fonction de la durée totale d'enregistrement, des moyens de sélection (13) pourvus de deux ensembles d'entrées (e'1, e'2) et adaptés à commuter l'un ou l'autre ensemble d'entrées à des moyens (16) de décodage d'adresses contrôlant l'accès à l'organe de mémorisation (17), certaines entrées de l'un ou l'autre ensembles d'entrées (e'1, e'2) étant connectées directement à des sorties respectives des deux registres (1, 2), d'autres entrées de l'un et l'autre desdits ensembles (e'1, e'2) étant connectées aux sorties des secondes et quatrièmes sections respectives des deux registres (1, 2) par l'intermédiaire de moyens de commutation (9, 10) (11, 12), et un système de gestion (8) pour commander les moyens de commutation, les moyens de sélection et l'organe de mémorisation? et modifier le contenu des deux premières parties du second registre (2), de manière à sélectionner l'un des deux registres et intervertir l'ordre d'un certain nombre de sorties de ces dits registres, le système de gestion étant également adapté à engendrer des impulsions d'incrémentation de la première partie (1a) du premier registre et de la troisième partie (2c) du second registre.

7. - Dispositif selon la revendication 6, caractérisé en ce que les moyens de commutation comportent quatre multiplexeurs (9, 10, 11, 12) pourvus chacun de deux ensembles (e1, e2) de quatre entrées, les ensembles d'entrée (e1) et (e2) respectivement des multiplexeurs 9 et 10 d'une part et des multiplexeurs 11 et 12 d'autre part étant connectés respectivement aux sorties de la quatrième partie (1d) du premier registre (1) et (2d) du second registre (2), et les ensembles d'entrée (e2) et (e1) respectivement des multiplexeurs 9 et 10 d'une part et des multiplexeurs 11 et 12 d'autre part étant connectés respectivement aux sorties de la seconde partie (1b) du premier registre (1) et (2b) du second registre (2), ces quatre multiplexeurs étant commandés par le système de gestion (8) de manière à intervertir le contenu des parties (1b et 1d) (2b et 2d) des sorties des deux registres pour deux séries successives quelconques d'échantillons.

8. - Dispositif selon la revendication 6, caractérisé en ce qu'il comporte un ensemble de logique (6) commandé par un dérouleur de bande (7) et adapté à engendrer des impulsions de demande de lecture de l'organe de mémorisation (7), et en ce que les moyens pour incrémenter la quatrième partie (1d, 2d) des deux registres comportent deux comparateurs (3, 4) adaptés à comparer le contenu des troisièmes sections (1c, 2c) des deux registres (1, 2) avec un nombre prédéterminé, et à produire des impulsions aux instants de détection de l'égalité de ce contenu avec ledit nombre prédéterminé.

9. - Dispositif selon la revendication 7, caractérisé en ce que les multiplexeurs (9 à 12 et 13) sont actionnés par des signaux engendrés par des basculeurs bistables (14, 15) en réponse à des impulsions de commande produites par le système de gestion (8).

PL_I_7

**FIG.1**

**FIG.2**

FIG.3

0084746

PL_III_7
**FIG.4**

**FIG.5**

FIG.6

$T_1$   $T_2$   $T_3$   $T_{n-1}$   $T_n$

PL.IV.7

0084746

$R_0$  $R_1$  $R_{q-1}$  $E'(0,p+1)$  $R_q$  $R_{q+1}$ $E'(1,p+1)$ $E'(0,2p+1)$  $R_{2q}$  $E'(1,2p+1)$  $E'(0,kp)$ $R_{nq}$  $E'(1,kp)$ $R_{nq+1}$

$E'_{0,1}$
$E'_{0,2}$
$E'_{0,3}$

$Z_1$

$E'(q-1,1)$
$E'_{1,1}$
$E'_{1,2}$

$E'(q-1,p+1)$

$E'(q-1,2p+1)$

$E'(q-1,kp)$

$R_{0,1}$ $R_{1,1}$ $S11$  $R_{q,1}$ $R_{q+1,1}$ $S12$  $R_{2q,1}$ $S13$  $R_{nq,1}$ $R_{nq+1,1}$ $S1n$

$E'(0,p)$ $E'(1,p)$ $E'(q-1,2)$  $E'(0,2p)$ $E'(1,2p)$  $E'(0,3p)$ $E'(1,3p)$  $E'(0,N)$ $E'(1,N)$  $E'(q-1,N)$

$E'(q,1)$
$E'(q,2)$

$Z_2$

$E'(q+1,1)$
$E'(2q-1,1)$
$E'(2q-1,2)$

$E'(q,p+1)$

$R_{0,2}$ $R_{1,2}$ $S21$  $R_{q,2}$ $R_{q+1,2}$ $S22$  $R_{2q,2}$ $R_{2q+1,2}$ $S23$  $R_{nq,2}$ $R_{nq+1,2}$ $S2n$

$E'(q,p)$  $E'(q,N)$  $E'(2q-1,N)$

$E'(2q,1)$  $E'(3q-1,1)$

$Z_3$

$R_{0,3}$ $S31$

$E'(2q,p)$

$E'(nq,1)$
$E'(nq,2)$

$Z_n$

$E'[(n+1)q-1,1]$
$E'[(n+1)q-1,2]$

$R_{0n}$

$E'(nq,p)$ $E'[(n+1)q-1,p]$  $E'(mq,N)$  $E'[(m+1)q-1,N]$

$D$

PL.V.7

**FIG.7**

**FIG.8**

**FIG.10**

FIG.9

$E_{01}, \acute{E}_{01}$
$E_{01}, \acute{E}_{02}$

$E_{op}, \acute{E}_{op}$

$E_{o\,p+1}$

$E_{0,2p}$

| | | 1 | | | N+1 | | 2N+1 | 3N+1 | | N′ |
| | | 1′ | | | 2′ | | 3′ | 4′ | | |
| | | 2 | | | N+2 | | 2N+2 | 3N+2 | | 2N′ |
| | | (N+1)′ | | | (N+2)′ | | (N+3)′ | (N+4)′ | | |
| | | 3 | | | N+3 | | 2N+3 | 3N+3 | | 3N′ |
| | | (2N+1)′ | | | (2N+2)′ | | (2N+3)′ | (2N+4)′ | | |
| | | 4 | | | N+4 | | 2N+4 | 3N+4 | | 4N′ |
| | | (3N+1)′ | | | (3N+2)′ | | (3N+3)′ | (3N+4)′ | | |

| | | N | | | 2N | | 3N | 4N | |

PL.VI.7

00847746

PL.VII.7

FIG.11